# EUROPEAN PATENT SPECIFICATION

(11) **EP 4 539 651 B1**
(45) Date of publication and mention of the grant of the patent: **04.11.2026**
(21) Application number: 23383053.8
(22) Date of filing: 13.10.2023
(51) Int. Cl.: H10N 80/10

(54) **PLANAR GUNN OSCILLATOR DEVICE BASED ON DOPED GAN WITH GEOMETRICALLY DEFINED NANOCHANNEL AND SUBSTRATE TERMINAL AND MANUFACTURING METHOD THEREOF**
PLANARES GUNN-OSZILLATORBAUELEMENT AUF BASIS VON DOTIERTEM GAN MIT GEOMETRISCH DEFINIERTEM NANOKANAL UND SUBSTRATTERMINAL SOWIE HERSTELLUNGSVERFAHREN DAFÜR
DISPOSITIF D'OSCILLATEUR GUNN PLANAIRE À BASE DE GAN DOPÉ AVEC NANO-CANAL GÉOMÉTRIQUEMENT DÉFINI ET TERMINAL DE SUBSTRAT ET SON PROCÉDÉ DE FABRICATION

(43) Date of publication of application: 16.04.2025
(73) Proprietor: Universidad De Salamanca, 37008 Salamanca (ES)
(72) Inventor: Mateos López, Javier, Salamanca (ES); Pérez Santos, María Susana, Salamanca (ES); García Sánchez, Sergio, Salamanca (ES)
(74) Representative: Pons IP

(56) References cited:
- US-A- 5 256 579
- GARCÍA-SÁNCHEZ S ET AL: "On the Practical Limitations for the Generation of Gunn Oscillations in Highly Doped GaN Diodes", IEEE TRANSACTIONS ON ELECTRON DEVICES, vol. 70, no. 7, July 2023 (2023-07-01), pages 3447 - 3453, XP093147748, DOI: 10.1109/TED.2023.3271610.DigitalObjectIdentifier10.1109/TED.2023.3271610
- GARCÍA-SÁNCHEZ S ET AL: "A Deep Learning-Monte Carlo Combined Prediction of Side-Effect Impact Ionization in Highly Doped GaN Diodes", IEEE TRANSACTIONS ON ELECTRON DEVICES, vol. 70, no. 6, June 2023 (2023-06-01), pages 2981 - 2987, XP011941408, DOI: 10.1109/TED.2023.3265625
- GARCÍA-SÁNCHEZ S ET AL: "Optimization of the Epilayer Design for the Fabrication of Doped GaN Planar Gunn Diodes", IEEE TRANSACTIONS ON ELECTRON DEVICES, vol. 69, no. 2, February 2022 (2022-02-01), pages 514 - 520, XP093147745, DOI: 10.1109/TED.2021.3134927

## Description

### OBJECT OF THE INVENTION

The present invention relates to the field of nanoelectronics, and in particular, to the field of GaN-based Gunn diodes.

The invention relates to a high-power high-frequency (THz) planar Gunn oscillator based on doped GaN with geometrically-shaped nanochannel and a substrate terminal. The planar geometry allows to concentrate the electric field and manage the heating of the device. The substrate terminal suppresses the avalanche process due to impact-ionization.

### BACKGROUND ART

As of now, Gunn diodes are extensively used as oscillators applied to circuits within the fields of satellite communications, transportation, medical scanners, integrated circuit failure detection, and several other military and medical applications. This kind of diode is typically designed making use of semiconductor-based technologies such as GaAs or InP.

Currently, there are various commercial providers of Gunn diodes from different manufacturers, primarily manufactured using GaAs and InP, achieving operating frequencies in the range of 25-40 GHz, with output powers below 20 mW. As an alternative for obtaining high-frequency, high-power signals, circuits based on GaN High Electron Mobility Transistors (HEMTs) are used. These circuits allow the generation of fundamental oscillators with frequencies close to 200 GHz and output power nearing 10 dBm. From these fundamental oscillators, higher frequencies can be achieved using frequency multipliers, which enable the generation of up to 20 µW of power at 2.75 THz.

Traditionally, GaAs Gunn diodes have a vertical topology, with the cathode and the anode forming the uppermost and lowermost layers of the structure.

In contrast. GaN semiconductor has a wider band-gap than the above-mentioned materials, a high saturation velocity and a high breakdown field, thus making it suitable for high-power high-frequency applications.

Given the superior properties of GaN compared to typical materials like GaAs and InP, achieving Gunn oscillations in GaN structures would reduce the complexity and footprint of frequency-multiplication circuits. It would also result in circuits functioning at very high frequencies, providing high radio frequency powers. The use of GaN Gunn diodes could eliminate the need to design and manufacture frequency multipliers below 200-300 GHz, which are currently extremely costly, and increase the output power of multipliers in the THz range. A two-terminal planar Gunn oscillator with a nanochannel geometrically defined in a highly doped GaN active layer formed on a GaN-buffered SiC substrate is known, for example, from García-Sánchez S et al, IEEE Transactions on Electron Devices, vol. 70, no. 7, July 2023, pages 3447-3453. US 5,256,579 discloses a three-terminal planar Gunn oscillator having a finger-like Schottky gate electrode on a GaAs channel.

However, GaN devices, due to the much higher breakdown field (around 200 kV/cm), and the aim for generating above 100 GHz oscillations, suffer from three main issues both in vertical and planar configurations:
(i) The devices experience electric breakdown phenomena due to the high voltage that is needed for the oscillations to appear, so the contacts must be manufactured with complex structures (field-plates) in order to minimize the electric field along its edges.
(ii) Due to the high currents that appear, the self-heating effects are severe.
(iii) The associated parasitic capacitance imposes a limit on the oscillation frequency, so it is necessary to reduce the size of the device.

Problems (ii) and (iii) can be mitigated by manufacturing anodes with a very small surface (<1 µm²), which makes the technology even more complex and increases the likelihood of the appearance of hot spots, which can in turn lead to the failure of the device. These solutions are already known in the state of the art, in vertical designs, however, said solutions are not commonly used, as for the moment the appearance of Gunn oscillations has not been achieved.

### DESCRIPTION OF THE INVENTION

To solve the aforementioned problems, it is an object of the present invention to provide a high-power high-frequency planar Gunn oscillator based on doped GaN with geometrically-shaped nanochannel and a substrate terminal.

The planar Gunn oscillator of the invention comprises:
- a substrate terminal configured to have an omega shape with two side wings and one top portion,
- a substrate layer arranged in two unconnected portions on top of corresponding side wings,
- a buffer layer arranged on top of the substrate layer comprising a first face contacting the substrate layer provided with a recess on the first face and configured to receive the top portion of the substrate terminal,
- a highly-doped GaN active layer with low defect density arranged on top of the buffer layer and comprising a lower active layer face contacting the buffer layer, and
- cathode and anode terminals arranged on top of the active layer with a spacing defined by the cathode and anode terminals and configured to prevent crosstalk capacitances,

wherein the cathode and anode terminals define a longitudinal direction between them, and
wherein the active layer comprises a narrower portion extending to at least one layer between the active layer and the substrate terminal, formed between the cathode and the anode terminals and configured to focus an electric field far from the cathode and anode terminals and to manage self-heating by limiting the dissipated DC power by the planar Gunn oscillator.

The adequate choice of the length and the shape of the channel allows to adjust the oscillation frequency of the planar Gunn oscillator.

The GaN active layer is manufactured with low defect levels (ideally utilizing a native GaN substrate). The precise level depends on the manufacturing method.

In the planar design of the planar Gunn oscillator of the invention, the avoidance of the crosstalk capacitances may be achieved by placing the cathode and anode terminals separated as far as possible from one another.

The narrower portion of the active layer may be formed by removing suitable parts of the active layer and of at least one layer below the active layer by means of dry etching or by avoiding the charge conduction through them by means of ion-implantation-induced amorphization (or any other suitable method known by the skilled in the art). In one embodiment, this operation defines two first recesses formed in a direction which is perpendicular to the longitudinal direction. The narrower portion must extend deep enough to completely avoid the electrical conduction through the active layer. Preferably, the narrower portion extends 50-100 nm below the active layer reaching one or more layers immediately below the active layer as it is described with further details below.

The narrower portion, as viewed from above, may take different contours. In a further embodiment, the two first recesses define a narrow portion which is wider in a side closest to the anode terminal than in a side closest to the cathode terminal. In particular, the narrower portion may present the contour of an isosceles trapezoid, thus forming a V-shaped portion of the active layer that gradually broadens from the cathode terminal towards the anode terminal, as viewed from above the oscillator.

Advantageously, this pattern can be repeated, enabling the production of devices containing multiple diodes in parallel. This arrangement effectively manages the device impedance and the level of dissipated power to limit heating.

In one embodiment, the narrower portion extends from the active layer down to the buffer layer.

More specifically, in an embodiment, the thickness of the active layer is comprised between 100 and 200 nm, and the thickness of the buffer layer is comprised between 1000 and 2000 nm. In this embodiment, the thickness of the parts of the buffer layer below the first recesses is between 50 and 100 nm less, that is, between 900 and 950 nm for the lower end of the range, and between 1900 and 1950 nm for the higher end of the range.

The walls that connect each side wing with the top portion may be straight. or curved and oriented in a vertical or slant direction.

The substrate layer is preferably made of GaN, but other materials such as sapphire, Si, SiC and diamond are suitable as well.

If the substrate layer is not made of GaN, an additional nucleation layer is provided between the substrate layer and the buffer layer arranged in two unconnected portions on top of the substrate layer. The nucleation layer improves the GaN crystal quality by adapting the lattice constant of the substrate to that of GaN.

The substrate terminal serves as a control terminal reducing avalanche processes due to impact ionization. To enhance this suppression effect, the substrate terminal is shaped having a recess towards the active layer such that a portion of the substrate terminal is close to the active layer: the closer to the layer, the stronger the effect. The thickness of the substrate layer must be minimized for efficient operation of the substrate terminal.

The buffer layer may be non-doped or doped with Fe or C at a concentration equal to or below 5x10¹⁸ cm⁻³. The purpose of this layer is to prevent current leakage from the active layer.

To further mitigate leakage currents from the active layer, an additional dielectric layer is interposed between the substrate terminal and the substrate layer. The dielectric layer has an omega shape covering the substrate terminal and may be incorporated to any embodiment of this description.

In a further embodiment, the leakage from the active layer towards the buffer layer can be decreased by interposing a first back barrier layer between the buffer layer and the active layer. This first back barrier layer increases an energy barrier that the electrons must jump through to reach the buffer layer, thus confining the electrons in the active layer. Thus, the planar Gunn oscillator of the invention comprises:
- the substrate terminal configured to have an omega shape with two side wings and one top portion,
- the substrate layer arranged in two unconnected portions on top of corresponding side wings,
- the buffer layer arranged on top of the substrate layer comprising a first face contacting the substrate layer provided with a recess on the first face and configured to receive the top portion of the substrate terminal,
- the first back barrier layer arranged on top of the substrate layer,
- the highly-doped GaN active layer with low defect density arranged on top of the first back barrier layer and comprising a lower active layer face contacting the first back barrier layer
- the cathode and anode terminals arranged on top of the active layer with a spacing defined by the cathode and anode terminals and configured to prevent crosstalk capacitances,
- wherein the cathode and anode terminals define a longitudinal direction between them, and
   a narrower portion is formed in the active layer extending to the first back barrier layer, and between the cathode and the anode terminals defining a geometrically shaped channel which focuses a high electric field far from the cathode and anode terminals and manages the self-heating by limiting the dissipated DC power by the planar Gunn oscillator.

More specifically, in a further embodiment deriving from the above one, the thickness of the active layer is comprised between 100 and 200 nm, the thickness of the first back barrier layer is comprised between 50 to 200 nm and the thickness of the buffer layer is comprised between 1000 and 2000 nm. In this embodiment, since the first recesses extend 50 to 100 nm below the active layer, depending on the combinations of thicknesses:
- the first recesses may completely remove the first back barrier layer below the first recesses without removing material from the buffer layer,
- the first recesses may completely remove the first back barrier layer below the first recesses down to part of the buffer layer,
- the first recesses may only remove part of the first back barrier layer without affecting the buffer layer.

In yet another embodiment, in addition to the first back barrier layer, a second back barrier layer is interposed between the first back barrier layer and the active layer to enhance the electron confinement effect. Thus, the planar Gunn oscillator of the invention comprises:
- the substrate terminal configured to have an omega shape with two side wings and one top portion,
- the substrate layer arranged in two unconnected portions on top of corresponding side wings,
- the buffer layer arranged on top of the substrate layer comprising a first face contacting the substrate layer provided with a recess on the first face and configured to receive the top portion of the substrate terminal,
- the first back barrier arranged on top of the substrate layer,
- the second back barrier arranged on top of the first back barrier,
- the highly-doped GaN active layer with low defect density arranged on top of the second back barrier and comprising a lower active layer face contacting the second back barrier
- the cathode and anode terminals arranged on top of the active layer with a spacing defined by the cathode and anode terminals and configured to prevent crosstalk capacitances,
- wherein the cathode and anode terminals define a longitudinal direction between them, and
   the narrower portion is formed in the active layer extending to the second back barrier or to the first back barrier, and between the cathode and the anode terminals, defining a geometrically shaped channel which focuses a high electric field far from the cathode and anode terminals and manages the self-heating by limiting the dissipated DC power by the planar Gunn oscillator.

More specifically, in a further embodiment deriving from the above one, the thickness of the active layer is comprised between 100 and 200 nm, the thickness of the first back barrier layer is comprised between 50 to 200 nm, the thickness of the second back barrier layer is comprised between 5 to 10 nm and the thickness of the buffer layer is comprised between 1000 and 2000 nm. In this embodiment, since the first recesses extend 50 to 100 nm below the active layer, they always pierce through the second back barrier layer in any combination of the above thicknesses and further depending on the combinations of thicknesses:
- the first recesses may completely remove the first back barrier layer below the first recesses without removing material from the buffer layer,
- the first recesses may completely remove the first back barrier layer below the first recesses down to part of the buffer layer,
- the first recesses may only remove part of the first back barrier layer without affecting the buffer layer.

The second back barrier layer may be made of AIN and the first back barrier layer may be made of AlₓGa₁₋ₓN, where x is between 0.15 and 0.30.

The first and second back barrier layers help decrease to a greater extent the chances of impact ionization and thus avalanche processes.

The layered structure and the geometry of the planar Gunn oscillator of the invention may be manufactured making use of semiconductor-based technologies such as GaAs or InP.

To better understand the features of the invention, a manufacturing method of the planar Gunn oscillator is described next, comprising the steps of:
First, a substrate layer is provided, and, depending on the embodiment, a nucleation layer on top of the substrate layer. Then, a buffer layer is formed on top of the nucleation layer (if there is one) or the substrate layer. Next, the first back barrier and the second back barrier may be optionally formed on top of the buffer layer, according to the embodiments herein described. Next, an active layer is formed on top of the first back barrier (if present), the second back barrier (if present) or the buffer layer. An anode terminal and a cathode terminal are placed on top of the active layer one in front of the other.

As described above, the narrower portion of the active layer may be formed by removing suitable parts of the active layer and of at least one layer between the active layer and the substrate terminal by means of dry etching or by avoiding the charge conduction through them by means of ion-implantation-induced amorphization (or any other suitable method known by the skilled in the art).

Material is then removed from the substrate layer, the nucleation layer if present, and part of the buffer layer, forming a terminal recess in a direction perpendicular to the longitudinal direction defined by the anode and the cathode terminals, and a width smaller than the width of the layers, slicing into two unconnected portions each of the substrate layer and the nucleation layer (if present) and forming the recess of the buffer layer.

Next, a dielectric is deposited and a continuous substrate terminal is formed in the terminal recess, contacting and covering the two unconnected portions and the buffer layer in the recess.

The omission of the substrate terminal in the above oscillator, which forms a layered device hereinafter called "geometrically-shaped planar Gunn diode" (GS-PGD) results in device burnout at the necessary voltages for Gunn oscillation onset. This is due to the emergence of impact ionization processes within the GaN buffer layer (as the design is intended to minimize thermal effects). The substrate terminal is introduced to mitigate the number of impact ionizations, creating a device hereinafter called "three-terminal geometrically-shaped planar Gunn diode" (3T-GS-PGD).

The implementation of this third terminal and the application of an appropriate additional voltage to it constitute the fundamental innovation introduced by this invention. This innovation leads to a new device that hampers conduction through the buffer and mitigates the electric field concentration in specific regions of the structure, thereby preventing device breakdown.

In essence, this could represent a significant advancement in the development of applications in medicine, scanning, scientific research, and other fields that require high powers at frequencies near or above the THz range.

Simulations of the planar Gunn oscillator of the invention indicate the possibility of obtaining Gunn oscillations in GaN when applying fields exceeding 200 kV/cm (the field at which the v-E characteristic reaches its maximum). However, experimental demonstration of this phenomenon is currently nonexistent.

### DESCRIPTION OF THE DRAWINGS

To complement the description being made and in order to aid towards a better understanding of the characteristics of the invention, in accordance with a preferred example of practical embodiment thereof, a set of drawings is attached as an integral part of said description wherein, with illustrative and non-limiting character, the following has been represented:
Figure 1 shows the different layers comprising the layer configuration of a preferred embodiment of the invention.
Figure 2 shows a comparison of impact ionization counts between the GS-PGD and the 3T-GS-PGD cases for two separations between the substrate layer and the active layer and two voltages between the anode and cathode terminals for a range of voltages applied to the substrate layer.

### PREFERRED EMBODIMENTS OF THE INVENTION

A preferred embodiment of the invention is presented and illustrated by the accompanying figures.

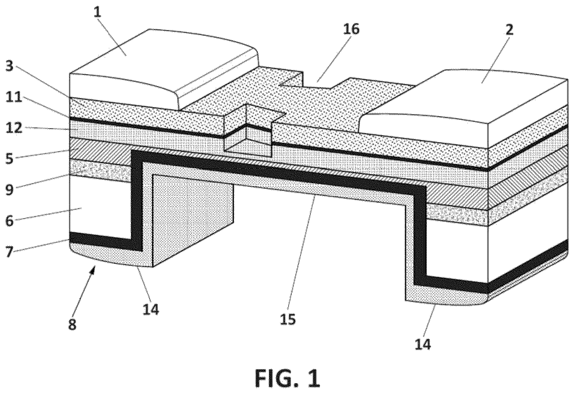

The layer structure of this preferred embodiment of the invention is shown in figure 1. It consists of:
- a substrate terminal (8) having an omega shape with two wings (14) and a top portion (15),
- a dielectric layer (7) arranged on top of the substrate terminal (8) with an omega shape and having a thickness of 10 to 50 nm,
- a substrate layer (6) arranged in two unconnected portions on top of the dielectric layer (7),
- a nucleation layer (9) arranged in two unconnected portions on top of the substrate layer (6),
- a buffer layer (5) comprising a first face contacting the substrate layer (6) provided with a recess on the first face configured to receive the top portion of the dielectric layer (7). The buffer layer (5) is made of semi-insulating GaN non-doped or doped with Fe or C impurities at a concentration below 5x10¹⁸ cm⁻³ to minimize conduction through it and has a thickness of 1500 nm,
- a first barrier layer (12) made of AlₓGa₁₋ₓN (where x is between 0.15 and 0.30) provided on top of the buffer layer (5) with a thickness of 200 nm, and a thin second back barrier layer (11) made of AIN provided on top of the first back barrier layer (12) with a thickness of 7 nm,
- a highly-doped active layer (3) made of GaN with low defect density arranged on top of the top back barrier layer (11) having a thickness between 100 to 200 nm wherein the GaN is doped with donor impurities at a concentration of 10¹⁸ to 10²⁰ cm⁻³,
- cathode (1) and anode (2) terminals arranged sitting on top of the active layer (3) with a spacing of 3 µm defined by the cathode (1) and anode (2) terminals and configured to prevent crosstalk capacitances, wherein the cathode (1) and anode (2) terminals define a longitudinal direction between them.

In this embodiment, the width of all the layers measured in the longitudinal direction is at least 3 µm and accommodate the cathode (1) and anode (2) terminals with a spacing of 3 µm. Other spacing values are useful provided they prevent crosstalk capacitances.

The side wings (14), the top portion (15) and two walls that connect each side wing (14) with the top portion (15) are straight and vertical.

The active layer is responsible for electron transport and Gunn oscillations.

The dielectric layer (7) covers the substrate terminal (8) such that the dielectric layer (7) is between the substrate terminal (8) and the substrate layer (6). The dielectric layer (7) comprises an upper portion that is configured to fit in the recess of the buffer layer (5) and to prevent current flow between the substrate terminal (8) and the substrate layer (6).

The active layer (3) comprises a narrower portion (16) defined by first recesses that extend 70 nm below the active layer (3) piercing through the second back barrier layer and reaching the first back barrier layer. In particular, the first recesses leave unremoved below themselves a portion of the first back barrier layer with a thickness of $200 - \left(70-7\right) = 137 nm ,$ formed in a direction which is perpendicular to the longitudinal direction thus avoiding the conduction through the active layer. The narrower portion (16) is wider in the side closest to the anode terminal than in the side closest to the cathode terminal. In particular, the active layer has the contour of an isosceles trapezoid as viewed from above the oscillator which smallest parallel side face the cathode terminal (1) and which largest parallel side face the anode terminal (2).

In order to provide a better avalanche-avoiding effect, the distance between the top portion (15) of the substrate terminal (8) and the active layer (3) is less than 1000 nm, such that when the substrate terminal (8) is subjected to a voltage, it is possible to reduce the number of impact ionizations and thus to prevent avalanche processes. Regarding the composition of the dielectric layer (7), a high-κ dielectric such as HfO₂ is preferred in order to decrease current leakage through the substrate terminal, but other substances such as SiO₂, Si₃N₄, Ga₂O₃ are suitable too.

The substrate layer (6) is made of SiC for a better thermal management. Therefore, the AlN/AlGaN nucleation layer (9) is provided to improve the GaN active layer crystal quality by adapting the lattice constant of the substrate layer (5) to that of GaN.

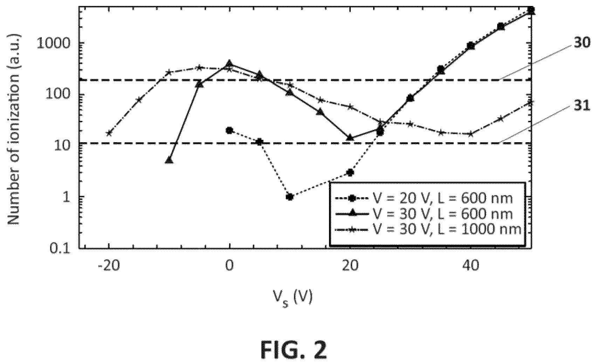

To help appreciate the advantages of the disclosed invention, figure 2 shows a graph representing the results of Monte-Carlo simulations of a GS-PDG and a 3T-GS-PDG devices wherein the horizontal axis represents the voltage applied to the substrate terminal (8) (*V_{S}*) of a 3T-GS-PDG and the vertical axis represents in a logarithmic scale the number of ionizations in arbitrary units.

The horizontal broken lines represent the number of ionizations of a GS-PGD, that is, an oscillator without the substrate terminal (8), when a voltage of 30 V (30) and 20 V (31) is applied between the cathode (1) and anode terminals (2).

As it is apparent, when the substrate terminal (8) is added to the layered oscillator forming the oscillator object of the invention, the number of ionizations is reduced for some values of substrate voltage.

More precisely, the line with dots represents the behavior of an oscillator as described in the invention with 20 V between the anode (2) and cathode (1) terminals and a distance between the active layer (3) and the substrate terminal (6) of 600 nm. Compared to the corresponding broken line (31), for a range between approximately 10 V and 20 V of voltage applied to the substrate terminal (8), the number of ionizations is substantially decreased.

The line with triangles represents the behavior of an oscillator as described in the invention with 30 V between the anode (2) and cathode (1) terminals and a distance between the active layer (3) and the substrate terminal (6) of 600 nm. Compared to the corresponding broken line (30), for a range between approximately 10 V and 30 V of voltage applied to the substrate terminal (8), the number of ionizations is substantially decreased.

The line with stars represents the behavior of an oscillator as described in the invention with 30 V between the anode (2) and cathode (1) terminals and a distance between the active layer (3) and the substrate terminal (6) of 1000 nm. Compared to the corresponding broken line (30), for a range between approximately 10 V and at least 50 V of voltage applied to the substrate terminal (8), the number of ionizations is substantially decreased.

Also, in all the cases, for high enough negative voltages impact ionization mechanisms are almost completely suppressed.

## Claims

1. A high-power high-frequency planar Gunn oscillator based on doped GaN, comprising:
- a substrate terminal (8) configured to have an omega shape with two side wings (14) and one top portion (15),
- a substrate layer (6) arranged in two unconnected portions on top of corresponding side wings (14),
- a buffer layer (5) arranged on top of the substrate layer (6) comprising a first face contacting the substrate layer (6) provided with a recess on the first face which is configured to receive the top portion (15) of the substrate terminal (8),
- a highly-doped GaN active layer (3) with low defect density arranged on top of the buffer layer (5), and
- cathode (1) and anode (2) terminals arranged on top of the active layer (3) with a spacing defined by the cathode (1) and anode (2) terminals and configured to prevent crosstalk capacitances, wherein the cathode and anode terminals define a longitudinal direction between them,
wherein the active layer (3) comprises a narrower portion (16) extending to at least one layer between the active layer (3) and the substrate terminal (8), formed between the cathode (1) and the anode (2) terminals and configured to focus an electric field far from the cathode (1) and anode (2) terminals and to manage self-heating by limiting the dissipated DC power by the planar Gunn oscillator.

2. The planar Gunn oscillator of claim 1, further comprising two first recesses formed in a direction which is perpendicular to the longitudinal direction and defining the narrower portion (16), penetrating 50-100 nm between the active layer (3) and the substrate terminal (8).

3. The planar Gunn oscillator of claim 1, wherein the narrower portion (16) is wider in a side closest to the anode terminal than in a side closest to the cathode terminal.

4. The planar Gunn oscillator of claim 1, additionally comprising a dielectric layer (7) arranged on top of the substrate terminal (8) with an omega shape, covering the substrate terminal (8) such that the dielectric layer (7) is between the substrate terminal (8) and the substrate layer (6), the dielectric layer (7) comprising a upper portion that is configured to fit in the recess of the buffer layer (5) and to prevent current flow between the substrate terminal (8) and the substrate layer (6).

5. The planar Gunn oscillator of claim 1, additionally comprising a first back barrier layer (12) arranged between the buffer layer (5) and the active layer (3), the first back barrier layer (12) being configured to increase an energy barrier formed by the buffer layer (5).

6. The planar Gunn oscillator of claim 5, further comprising a second back barrier layer (11) arranged between the first back barrier layer (12) and the active layer (3), the second back barrier layer (11) being configured to increase an energy barrier formed by the buffer layer (5) and the first back barrier layer (12).

7. The planar Gunn oscillator of claim 6, wherein the second back barrier layer (11) is made of AIN and the first back barrier layer is made of AlₓGa₁₋ₓN, where x is between 0.15 and 0.30.

8. The planar Gunn oscillator of claim 1, wherein the buffer layer (5) is made of either semi-insulating non-doped GaN or GaN that is doped with Fe or C impurities at a concentration equal to or below 5·10¹⁸ cm⁻³.

9. -The planar Gunn oscillator of claim 1, wherein the top portion (15) of the substrate terminal (8) is at a distance to the active layer (3) below 1000 nm.

10. -The planar Gunn oscillator of claim 1, wherein the active layer (3) is doped with donor impurities at a concentration of 10¹⁸ to 10²⁰ cm⁻³.

11. The planar Gunn oscillator of claim 6, wherein the thickness of the active layer (3) is in the range of 100 to 200 nm, the thickness of the buffer layer (5) is in the range of 1000 to 2000 nm, the thickness of the dielectric layer (7) is in the range of 10 to 50 nm, the thickness of the first back barrier layer (12) is in the range of 50 to 200 nm and the thickness of the second back barrier layer (11) is in the range of 5 to 10 nm.

12. -The planar Gunn oscillator of claim 1, wherein the substrate layer (6) is made of:
- a material selected from GaN, sapphire, Si, SiC and diamond; or
- any material other than GaN, further comprising a nucleation layer (9) arranged in two unconnected portions on top of the substrate layer (6) and below the buffer layer (5).

13. -A method for manufacturing the planar Gunn oscillator of any of claims 1 to 12, comprising the steps of:
- providing the substrate layer (6), the buffer layer (5), and the active layer (3),
- forming the anode (2) and the cathode (1) terminals,
- removing material from the substrate layer (6) and part of the buffer layer (5) forming a terminal recess in a direction perpendicular to the longitudinal direction defined by the anode (2) and the cathode (1) terminals having a width defined by the longitudinal direction smaller than the width of the layers (5, 6), slicing into two unconnected portions the substrate layer (6) and forming the recess of the buffer layer (5), leaving parts of the buffer layer (5) exposed,
- forming the substrate terminal (8) in the terminal recess in contact with the substrate layer (6) and recess of the buffer layer (5), and
- forming the narrower portion (16) by removing parts of the active layer (3) and of at least one layer between the active layer and the substrate terminal (8) by means of dry etching or by avoiding charge conduction through them by means of ion-implantation-induced amorphization, these removed parts forming the first recesses.

14. The method of claim 13, wherein
- a/the nucleation layer (9) is provided between the buffer layer (5) and the substrate layer (6), and material is removed from the nucleation layer (9) to form the terminal recess,
- a/the first back barrier layer (12) and a/the second back barrier layer (11) are provided between the active layer (3) and the buffer layer (5) and parts of the first back barrier layer (12) and the second back barrier layer (11) are removed to form the first recesses.

## Patentansprüche

1. Planarer Hochleistungs-Hochfrequenz-Gunn-Oszillator auf Basis von dotiertem GaN, umfassend:
- ein Substratterminal (8), das dazu konfiguriert ist, eine Omega-Form mit zwei Seitenflügeln (14) und einem oberen Abschnitt (15) aufzuweisen,
- eine Substratschicht (6), die in zwei nicht miteinander verbundenen Abschnitten auf den entsprechenden Seitenflügeln (14) angeordnet ist,
- eine auf der Substratschicht (6) angeordnete Pufferschicht (5), die eine erste Fläche umfasst, die mit der Substratschicht (6) in Kontakt steht und auf der ersten Fläche mit einer Aussparung versehen ist, die dazu konfiguriert ist, den oberen Abschnitt (15) des Substratterminals (8) aufzunehmen,
- eine hochdotierte GaN-Aktivschicht (3) mit geringer Defektdichte, die auf der Pufferschicht (5) angeordnet ist, und
- Kathoden- (1) und Anodenterminale (2), die auf Aktivschicht (3) angeordnet sind, mit einem durch die Kathoden- (1) und Anodenterminale (2) definierten Abstand und dazu konfiguriert, Übersprechkapazitäten zu verhindern, wobei die Kathoden- und Anodenterminale zwischen sich eine Längsrichtung definieren,
wobei die Aktivschicht (3) einen schmaleren Abschnitt (16) umfasst, der sich bis zu mindestens einer Schicht zwischen der Aktivschicht (3) und dem Substratterminal (8) erstreckt, der zwischen dem Kathoden- (1) und dem Anodenterminal (2) ausgebildet und dazu konfiguriert ist, ein elektrisches Feld weit entfernt von dem Kathoden- (1) und dem Anodenterminal (2) zu fokussieren und die Selbsterwärmung zu verwalten, indem die vom planaren Gunn-Oszillator abgegebene Gleichstromleistung begrenzt wird.

2. Planarer Gunn-Oszillator nach Anspruch 1, ferner umfassend zwei erste Aussparungen, die in einer zur Längsrichtung senkrechten Richtung ausgebildet sind und den schmaleren Abschnitt (16) definieren, wobei sie 50-100 nm tief zwischen der Aktivschicht (3) und dem Substratterminal (8) eindringen.

3. Planarer Gunn-Oszillator nach Anspruch 1, wobei der schmalere Abschnitt (16) auf der dem Anodenterminal am nächsten gelegenen Seite breiter ist als auf der dem Kathodenterminal am nächsten gelegenen Seite.

4. Planarer Gunn-Oszillator nach Anspruch 1, zusätzlich umfassend eine dielektrische Schicht (7), die auf dem Substratterminal (8) mit einer Omega-Form angeordnet ist, wobei das Substratterminal (8) derart abgedeckt wird, dass sich die dielektrische Schicht (7) zwischen dem Substratterminal (8) und der Substratschicht (6) befindet, wobei die dielektrische Schicht (7) einen oberen Abschnitt umfasst, der dazu konfiguriert ist, in die Aussparung der Pufferschicht (5) zu passen und einen Stromfluss zwischen dem Substratterminal (8) und der Substratschicht (6) zu verhindern.

5. Planarer Gunn-Oszillator nach Anspruch 1, zusätzlich umfassend eine erste hintere Barriereschicht (12), die zwischen der Pufferschicht (5) und der Aktivschicht (3) angeordnet ist, wobei die erste hintere Barriereschicht (12) dazu konfiguriert ist, die durch die Pufferschicht (5) gebildete Energiebarriere zu erhöhen.

6. Planarer Gunn-Oszillator nach Anspruch 5, ferner umfassend eine zweite hintere Barriereschicht (11), die zwischen der ersten hinteren Barriereschicht (12) und der Aktivschicht (3) angeordnet ist, wobei die zweite hintere Barriereschicht (11) dazu konfiguriert ist, eine durch die Pufferschicht (5) und die erste hintere Barriereschicht (12) gebildete Energiebarriere zu erhöhen.

7. Planarer Gunn-Oszillator nach Anspruch 6, wobei die zweite hintere Barriereschicht (11) aus AIN hergestellt ist und die erste hintere Barriereschicht aus AlₓGa₁₋ₓN hergestellt ist, wobei x zwischen 0,15 und 0,30 liegt.

8. Planarer Gunn-Oszillator nach Anspruch 1, wobei die Pufferschicht (5) entweder aus halbisolierendem, undotiertem GaN oder aus GaN hergestellt ist, das mit Fe- oder C-Verunreinigungen in einer Konzentration von höchstens 5·10¹⁸ cm⁻³ dotiert ist.

9. Planarer Gunn-Oszillator nach Anspruch 1, wobei der obere Abschnitt (15) des Substratterminals (8) in einem Abstand zur Aktivschicht (3) von weniger als 1000 nm liegt.

10. Planarer Gunn-Oszillator nach Anspruch 1, wobei die Aktivschicht (3) mit Donatorverunreinigungen in einer Konzentration von 10¹⁸ bis 10²⁰ cm⁻³ dotiert ist.

11. Planarer Gunn-Oszillator nach Anspruch 6, wobei die Dicke der Aktivschicht (3) im Bereich von 100 bis 200 nm liegt, die Dicke der Pufferschicht (5) im Bereich von 1000 bis 2000 nm liegt, die Dicke der dielektrischen Schicht (7) im Bereich von 10 bis 50 nm liegt, die Dicke der ersten hinteren Barriereschicht (12) im Bereich von 50 bis 200 nm liegt und die Dicke der zweiten hinteren Barriereschicht (11) im Bereich von 5 bis 10 nm liegt.

12. Planarer Gunn-Oszillator nach Anspruch 1, wobei die Substratschicht (6) hergestellt ist aus:
- einem Material, das aus GaN, Saphir, Si, SiC und Diamant ausgewählt ist; oder
- einem beliebigen anderen Material als GaN, ferner umfassend eine Nukleationsschicht (9), die in zwei nicht miteinander verbundenen Abschnitten auf der Substratschicht (6) und unterhalb der Pufferschicht (5) angeordnet ist.

13. Verfahren zum Herstellen des planaren Gunn-Oszillators nach einem der Ansprüche 1 bis 12, umfassend die Schritte:
- Bereitstellen der Substratschicht (6), der Pufferschicht (5) und der Aktivschicht (3),
- Ausbilden der Anoden- (2) und Kathodenterminale (1),
- Entfernen von Material aus der Substratschicht (6) und einem Teil der Pufferschicht (5), um eine Terminalaussparung in einer Richtung senkrecht zur Längsrichtung auszubilden, die durch die Anoden- (2) und Kathodenterminale (1) definiert ist, wobei die in Längsrichtung definierte Breite kleiner ist als die Breite der Schichten (5, 6), wobei die Substratschicht (6) in zwei nicht miteinander verbundene Abschnitte aufgeteilt wird und die Aussparung der Pufferschicht (5) ausgebildet wird, wobei Teile der Pufferschicht (5) freigelegt bleiben,
- Ausbilden des Substratterminals (8) in der Terminalaussparung in Kontakt mit der Substratschicht (6) und der Aussparung der Pufferschicht (5), und
- Ausbilden des schmaleren Abschnitts (16) durch Entfernen von Teilen der Aktivschicht (3) und mindestens einer Schicht zwischen der Aktivschicht und dem Substratterminal (8) mittels Trockenätzung oder durch Vermeiden der Ladungsleitung durch diese hindurch mittels durch Ionenimplantation induzierter Amorphisierung, wobei diese entfernten Teile die ersten Aussparungen bilden.

14. Verfahren nach Anspruch 13, wobei
- eine/die Keimbildungsschicht (9) zwischen der Pufferschicht (5) und der Substratschicht (6) bereitgestellt wird und Material von der Keimbildungsschicht (9) entfernt wird, um die Terminalaussparung auszubilden,
- eine/die erste hintere Barriereschicht (12) und eine/die zweite hintere Barriereschicht (11) zwischen der Aktivschicht (3) und der Pufferschicht (5) bereitgestellt werden, und Teile der ersten hinteren Barriereschicht (12) und der zweiten hinteren Barriereschicht (11) entfernt werden, um die ersten Aussparungen auszubilden.

## Revendications

1. Oscillateur Gunn planaire haute puissance et haute fréquence basé sur le GaN dopé, comprenant :
- une borne de substrat (8) conçue pour avoir un profilé en oméga avec deux ailes latérales (14) et une portion de dessus (15),
- une couche de substrat (6) agencée en deux portions non reliées au-dessus d'ailes latérales correspondantes (14),
- une couche tampon (5) agencée au-dessus de la couche de substrat (6) comprenant une première face en contact avec la couche de substrat (6) pourvue d'un évidement sur la première face qui est conçu pour recevoir la portion de dessus (15) de la borne de substrat (8),
- une couche active en GaN hautement dopée (3) à faible densité de défauts agencée au-dessus de la couche tampon (5), et
- des bornes de cathode (1) et d'anode (2) agencées au-dessus de la couche active (3) avec un espacement défini par les bornes de cathode (1) et d'anode (2) et conçues pour empêcher les capacités de diaphonie, dans lequel les bornes de cathode et d'anode définissent une direction longitudinale entre elles,
dans lequel la couche active (3) comprend une portion plus étroite (16) s'étendant jusqu'à au moins une couche entre la couche active (3) et la borne de substrat (8), formée entre les bornes de cathode (1) et d'anode (2) et conçue pour focaliser un champ électrique loin des bornes de cathode (1) et d'anode (2) et pour gérer l'auto-échauffement en limitant la puissance CC dissipée par l'oscillateur Gunn planaire.

2. Oscillateur Gunn planaire selon la revendication 1, comprenant en outre deux premiers évidements formés dans une direction perpendiculaire à la direction longitudinale et définissant la portion plus étroite (16), pénétrant de 50 à 100 nm entre la couche active (3) et la borne de substrat (8).

3. Oscillateur Gunn planaire selon la revendication 1, dans lequel la portion plus étroite (16) est plus large sur un côté le plus proche de la borne d'anode que sur un côté le plus proche de la borne de cathode.

4. Oscillateur Gunn planaire selon la revendication 1, comprenant en outre une couche diélectrique (7) agencée au-dessus de la borne de substrat (8) avec un profilé en oméga, recouvrant la borne de substrat (8) de telle sorte que la couche diélectrique (7) est entre la borne de substrat (8) et la couche de substrat (6), la couche diélectrique (7) comprenant une portion de dessus qui est conçue pour s'adapter dans l'évidement de la couche tampon (5) et pour empêcher une circulation de courant entre la borne de substrat (8) et la couche de substrat (6).

5. Oscillateur Gunn planaire selon la revendication 1, comprenant en outre une première couche barrière arrière (12) agencée entre la couche tampon (5) et la couche active (3), la première couche barrière arrière (12) étant conçue pour augmenter une barrière d'énergie formée par la couche tampon (5).

6. Oscillateur Gunn planaire selon la revendication 5, comprenant en outre une seconde couche barrière arrière (11) agencée entre la première couche barrière arrière (12) et la couche active (3), la seconde couche barrière arrière (11) étant conçue pour augmenter une barrière d'énergie formée par la couche tampon (5) et la première couche barrière arrière (12).

7. Oscillateur Gunn planaire selon la revendication 6, dans lequel la seconde couche de barrière arrière (11) est constituée d'AIN et la première couche de barrière arrière est constituée AlₓGa₁₋ₓN, où x est entre 0,15 et 0,30.

8. Oscillateur Gunn planaire selon la revendication 1, dans lequel la couche tampon (5) est constituée soit de GaN semi-isolant non dopé, soit de GaN dopé avec des impuretés Fe ou C à une concentration égale ou en dessous de 5·10¹⁸ cm ⁻³.

9. Oscillateur Gunn planaire selon la revendication 1, dans lequel la portion de dessus (15) de la borne de substrat (8) est à une distance de la couche active (3) en dessous de 1 000 nm.

10. Oscillateur Gunn planaire selon la revendication 1, dans lequel la couche active (3) est dopée avec des impuretés donneuses à une concentration de 10¹⁸ à 10²⁰ cm ⁻³.

11. Oscillateur Gunn planaire selon la revendication 6, dans lequel l'épaisseur de la couche active (3) est dans la plage de 100 à 200 nm, l'épaisseur de la couche tampon (5) est dans la plage de 1 000 à 2 000 nm, l'épaisseur de la couche diélectrique (7) est dans la plage de 10 à 50 nm, l'épaisseur de la première couche barrière arrière (12) est dans la plage de 50 à 200 nm et l'épaisseur de la seconde couche barrière arrière (11) est dans la plage de 5 à 10 nm.

12. Oscillateur Gunn planaire selon la revendication 1, dans lequel la couche de substrat (6) est constituée de :
- un matériau choisi parmi le GaN, le saphir, le Si, le SiC et le diamant ; ou
- tout matériau autre que le GaN, comprenant en outre une couche de nucléation (9) agencée en deux portions non reliées au-dessus de la couche de substrat (6) et en dessous de la couche tampon (5).

13. Procédé de fabrication de l'oscillateur Gunn planaire selon l'une quelconque des revendications 1 à 12, comprenant les étapes consistant à :
- fournir la couche de substrat (6), la couche tampon (5) et la couche active (3),
- former les bornes d'anode (2) et de cathode (1),
- retirer du matériau de la couche de substrat (6) et d'une partie de la couche tampon (5) en formant un évidement de borne dans une direction perpendiculaire à la direction longitudinale définie par les bornes d'anode (2) et de cathode (1) ayant une largeur définie par la direction longitudinale plus petite que la largeur des couches (5, 6), découper en deux portions non reliées la couche de substrat (6) et former l'évidement de la couche tampon (5), en laissant des parties de la couche tampon (5) exposées,
- former la borne de substrat (8) dans l'évidement de borne en contact avec la couche de substrat (6) et l'évidement de la couche tampon (5), et
- former la partie plus étroite (16) en retirant des parties de la couche active (3) et d'au moins une couche entre la couche active et la borne de substrat (8) au moyen d'une gravure sèche ou en évitant la conduction de charge à travers elles au moyen d'une amorphisation induite par implantation ionique, ces parties retirées formant les premiers évidements.

14. Procédé selon la revendication 13, dans lequel
- une/la couche de nucléation (9) est fournie entre la couche tampon (5) et la couche de substrat (6), et du matériau est retiré de la couche de nucléation (9) pour former l'évidement de borne,
- une/la première couche barrière arrière (12) et une/la seconde couche barrière arrière (11) sont fournies entre la couche active (3) et la couche tampon (5) et des parties de la première couche barrière arrière (12) et de la seconde couche barrière arrière (11) sont retirées pour former les premiers évidements.
